# EUROPÄISCHE PATENTSCHRIFT

(11) **EP 0 905 277 B1**
(45) Veröffentlichungstag und Bekanntmachung des Hinweises auf die Patenterteilung: **16.04.2003**
(21) Anmeldenummer: 98116274.6
(22) Anmeldetag: 28.08.1998
(51) Int. Cl.: C23C 18/12, H01L 21/316, H01L 41/24, C23C 16/40

(54) **Herstellungsverfahren für eine Bi-haltige keramische Schicht, insbesondere aus Strontium-Wismut-Tantalat**
Process for making a Bi-containing ceramic layer like strontium-bismuth-tantalate
Procédé de fabrication d'une couche céramique au bismuth telle que strontium-bismuth-tantalate

(30) Priorität: 30.09.1997 DE 19743269
(43) Veröffentlichungstag der Anmeldung: 31.03.1999
(73) Patentinhaber: Infineon Technologies AG, 81669 München (DE)
(72) Erfinder: Hintermaier, Frank, 81373 München (DE); Mazure-Espejo, Carlos, 85604 Zorneding (DE)
(74) Vertreter: Zimmermann & Partner

(56) Entgegenhaltungen:
- EP-A- 0 877 100
- EP-A- 0 905 278
- US-A- 5 480 862
- US-A- 5 508 226
- PATENT ABSTRACTS OF JAPAN vol. 016, no. 133 (C-0925), 6.April 1992 & JP 03 295808 A (SUMITOMO ELECTRIC IND LTD), 26.Dezember 1991,
- DATABASE WPI Section Ch, Week 9343 Derwent Publications Ltd., London, GB; Class L03, AN 93-340129 XP002090880 & JP 05 247 650 A (NIKKO KYOSEKI KK) , 24.September 1993

## Beschreibung

Die Erfindung betrifft ein Herstellverfahren für eine keramische Schicht, die als Komponenten zumindest Bi, Sr und Ta enthält, insbesondere für eine keramische Schicht mit ferroelektrischen, paraelektrischen oder supraleitenden Eigenschaften.

In der Halbleitertechnologie findet die Verwendung von keramischen Dünnfilmschichten zunehmend Interesse. In dieser Substanzklasse gibt es Verbindungen mit supraleitenden, ferroelektrischen oder dielektrischen Eigenschaften mit hoher Dielektrizitätkonstante. Die beiden letztgenannten Verbindungsklassen bieten insbesondere Vorteile beim Einsatz als Speicherdielektrikum in Kondensatoren einer integrierten Schaltung. Bei den keramischen Substanzen handelt es sich um Oxide, die - neben Sauerstoff - mindestens zwei Komponenten aufweisen. Beispiele für die Komponenten sind u.a. Ba, Sr, Bi, Pb, Zr, La, Ti, Ta.

Ein Verfahren zur Herstellung einer keramischen Schicht ist z.B. aus der JP 03 295808 A bekannt. Dort werden zur Herstellung von Supraleitern Bi-oxyacetate und Sr-acetate mit weiteren Precursoren in wässriger Esigsäure gelöst, diese Lösung danach zum Entfernen der Essigsäure getrocknet und schließlich zum Erhalten einer keramischen Schicht erhitzt.

Ein Beispiel für eine Halbleiterschaltung mit einem Kondensator ist eine DRAM-Speicherzelle. Zur Erhöhung der Integrationsdichte kann sie als sogenannte Stacked Capacitor-Zelle realisiert werden, bei der der Speicherkondensator oberhalb des zugehörigen Auswahltransistors angeordnet ist. Einen wesentlichen Einfluß auf den Platzbedarf eines solchen Kondensators hat unter anderem die Wahl des Kondensatordielektrikums.

Konventionelle Kondensatoren benutzen als Speicherdielektrikum meist Siliziumoxid- bzw. -nitridschichten, die eine Dielektrizitätskonstante von maximal 8 besitzen. Die paraelektrische Materialien der genannten Substanzklasse, wie beispielsweise BST (Barium-Strontium-Titanat, (BaSr)TiO₃) und ähnliche besitzen eine Dielektrizitätskonstante ε > 150 und ermöglichen somit einen kleineren Kondensator bei gleicher Kapazität.

Derartige Speicherelemente mit einem paraelektrischen Material als Kondensatordielektrikum (DRAM) verlieren bei Ausfall der Versorgungsspannung ihre Ladung und somit ihre gespeicherte Information. Weiter müssen konventionelle Speicherelemente wegen des Restleckstroms ständig neu beschrieben werden (Refresh-Time). Der Einsatz eines ferroelektrischen Materials als Speicherdielektrikum erlaubt aufgrund der unterschiedlichen Polarisationsrichtungen den Bau eines nichtflüchtigen Speichers, der seine Information bei Ausfall der Versorgungsspannung nicht verliert und nicht ständig neu beschrieben werden muß. Der Restleckstrom der Zelle beeinflußt nicht das gespeicherte Signal. Beispiele für ein derartiges ferroelektrisches Material aus der genannten Substanzklasse sind PZT (Blei-Zirkonium-Titanat, Pb(Zr,Ti)O₃) und SBT (Strontium-Bismuth-Tantalat, SrBi₂Ta₂O₉)

Da die Herstellung dieser neuen Ferro- und Paraelektrika im allgemeinen bei hohen Temperaturen in einer oxidierenden Atmosphäre erfolgt, wird insbesondere für die erste Kondensatorelektrode ein Material benötigt, das mit diesen Bedingungen kompatibel ist. Es wird üblicherweise Pt, Ru, RuO₂ oder ein ähnliches Material eingesetzt.

Für die Herstellung von keramischen Dünnfilmen sind drei wesentliche Methoden bekannt: Ein Sputterprozeß, ein CVD-Verfahren und ein sogenannter Sol-Gel-Prozeß. Beim Sol-Gel-Prozeß werden metallorganische Ausgangschemikalien in der Regel in einem unpolaren, aromatischen Lösungsmittel gelöst (beispielsweise in Xylol), die Lösung auf einen Wafer aufgebracht und abgeschleudert (spin-on-Verfahren). Der so erhaltene dünne Film aus metallorganischen Molekülen wird anschließend bei Gegenwart von Sauerstoff in einen Oxidfilm überführt. Bei einer anschließenden Temperung, die im Fall von SBT typischerweise in einem Temperaturbereich von 700 bis 800° C durchgeführt wird, geht dieser Oxidfilm in die Phase mit den gewünschten elektrischen Eigenschaften über. Im Fall einer SBT-Schicht wird die Schichtperovskit-Phase mit ferroelektrischen Eigenschaften gebildet, bei BST oder PZT liegt ein einfacher Perovskit vor (Temperung bei 450 - 650°C). Ein Beispiel für einen derartigen Sol-Gel-Prozeß ist in der internationalen Patentanmeldung WO 93/12538 beschrieben. Bei diesen Herstellverfahren ist die Verwendung der üblichen Lösungsmittel, insbesondere der unpolaren aromatischen Lösungsmittel, aufgrund der Giftigkeit und der potentiellen Krebsgefahr der Dämpfe problematisch.

Ein Herstellverfahren für SBT ist ferner in dem Artikel T. Boyle et al in Journal of Material Research, Vol. 11, Nr. 9, Sept. 96, Seiten 2274 bis 2281 beschrieben. Dabei werden der Ta-haltige und der Sr-haltige Precursor in Essigsäure gelöst. In dem Artikel wird festgestellt, daß der Bi-haltige Precursor nicht in Essigsäure löslich ist, so daß er in Pyridin gelöst werden muß. Nachteilig bei diesem Verfahren ist der Aufwand durch die zwangsläufige Verwendung zweier verschiedener Ausgangslösungen, die unmittelbar vor der Waferbeschichtung gemischt werden. Darüber hinaus besteht das Problem der Alterung der die Essigsäure enthaltenden Ausgangslösung. In dieser reagiert der Ta-haltige Precursor (Tantalethoxid) mit der Essigsäure unter Bildung von Essigester und Wasser. Das Wasser hydrolisiert den Ta-haltigen Precursor, wodurch hochmolekulare Tantaloxidcluster gebildet werden. Im Laufe der Zeit wird kolloidales und später suspendiertes Ta₂O₅ erzeugt, was an einer Viskositätsänderung nach ca. 1 Woche und einer Trübung nach ca. 2 Wochen erkennbar ist. Daher ist die Aufbewahrung des Ta-haltigen Precursors in Essigsäure auf Dauer nicht möglich.

Aufgabe der vorliegenden Erfindung ist es, ein einfaches Herstellverfahren für eine keramische Schicht, die als Komponenten zumindest Bi, Sr und Ta enthält, anzugeben, bei dem die Langzeitstabilität des Ta-haltigen Precursors und der Ausgangslösung zur Herstellung der keramischen Schicht bei gleichzeitig verbesserter Löslichkeit des Bi-haltigen Precursors erhöht ist.

Diese Aufgabe wird durch ein Verfahren mit den Merkmalen des Anspruchs 1 gelöst.

Bei der Erfindung wird als Lösungsmittel für den Bi-haltigen Precursor eine organische Säure CₙH₂ₙ₊₁COOH mit n=0, 1 oder2, also Ameisensäure, Essigsäure oder Propionsäure, eingesetzt. Überraschenderweise wurde festgestellt, daß - im Gegensatz zur Aussage in dem Artikel von Boyle et al - in diesen Säuren die gängigen Precursoren, insbesondere auch Bi-haltige Precursoren, löslich sind. Werden die Precursoren zusammengegeben und bspw. Essigsäure zugefügt, wurde eine gute Löslichkeit beobachtet. Dies kann auf kooperative Effekte der einzelnen Precursoren zurückgeführt werden, beispielsweise durch Änderung der Polarität der Essigsäure durch einen Precursor oder durch Wechselwirkungen der Precursoren untereinander. Durch Zugabe von Wasser kann die Löslichkeit noch verbessert werden. Die gelösten Precursoren werden dann in einem Spin-on-Verfahren auf das Substrat aufgebracht, der Film wird getrocknet und bei höheren Temperaturen, typischerweise >250° C, ausgeheilt.

In weiterer Ausgestaltung der Erfindung kann auch das Problem der mangelnden Langzeitstabilität gelöst werden. Beim oben erläuterten Beispiel SBT werden der Bi-haltige Precursor und der der Sr-haltige Precursor in bspw. Essigsäure gelöst. Diese Lösung L1 ist stabil, keiner der Precursoren reagiert chemisch mit der Essissäure. Durch Zugabe von Wasser kann eine weiter erhöhte Langzeitstabilität erreicht werden (L2). Der Ta-haltige Precursor wird nun in einem anderen Lösungsmittel gelöst und diese Mischung dann einer Mischapparatur mit L1 oder L2 vermischt.
Die Lösung und der gelöste Ta-haltige Precursor werden direkt innig vermischt, wobei im Fall einer wasserhaltigen Lösung (L2) die Vermischung schnell erfolgen muß, um die Konzentration des Ta-haltigen Precursors schnell zu senken und so eine rasche Koagulation des Hydrolyseprodukts zu verhindern. Das erhaltene Gemisch wird im Spin-on-Verfahren auf das Substrat aufgebracht.
Vorteil dieser Variante ist es, daß lokale Überkonzentrationen des Ta-haltigen Precursors bei der Vermischung vermieden werden, das Risiko der Hydrolyse also geringer ist. Ferner entfällt das Heizen. Als Lösungsmittel kommen solche Stoffe in Betracht, die nicht mit dem Precursor unter Bildung von Wasser reagieren. Ein Beispiel ist Tetrahydrofuran (THF), welches lediglich ein geringes gesundheitsgefährdendes Potential hat.

Ein wesentlicher Vorteil der vorliegenden Erfindung besteht in der Verwendung der ungiftigen Säure als Lösungsmittel für den Bi-haltigen Precursor und ggf. weiterer Precursoren. Dadurch ergeben sich geringere Schutzmaßnahmen und eine einfacherere Entsorgung. Ein weiterer Vorteil der Säuren ist, daß sie aufgrund ihrer Polarität nicht nur imstande sind, die bislang verwendeten metallorganischen Chemikalien zu lösen, sondern darüber auch andere, weniger kompliziert aufgebaute Verbindungen lösen kann. Damit steht ein breites Spektrum an Ausgangschemikalien zur Verfügung. Die bislang verwendeten metallorganischen Chemikalien haben darüberhinaus die Nachteile, daß sie einerseits am Markt nicht immer gut verfügbar sind, andererseits oft nur mit geringem Reinheitsgrad bezogen werden können. Die genannten Vorteile führen außerdem zu einer Kostenreduktion.

Als Precursoren eignen sich in vielen Fällen die Acetate oder Oxyde der Metalle, ferner können die Metalle, insbesondere Sr, auch direkt in der Säure gelöst werden. Als Ta-haltiger Precurser können die Verbindungen Ta(OEt)₄(acac), Ta(OEt)₅ oder Ta(OMe)₅ eingesetzt werden.

Die Erfindung wird im folgenden anhand von Ausführungsbeispielen näher erläutert. In den Figuren 1 und 2 sind die Verfahrensabläufe schematisch dargestellt. Figur 3 zeigt als Beispiel für eine integierte Halbleiterstruktur mit einer erfindungsgemäß hergestellten Schicht eine FRAM-Speicherzelle im Querschnitt.

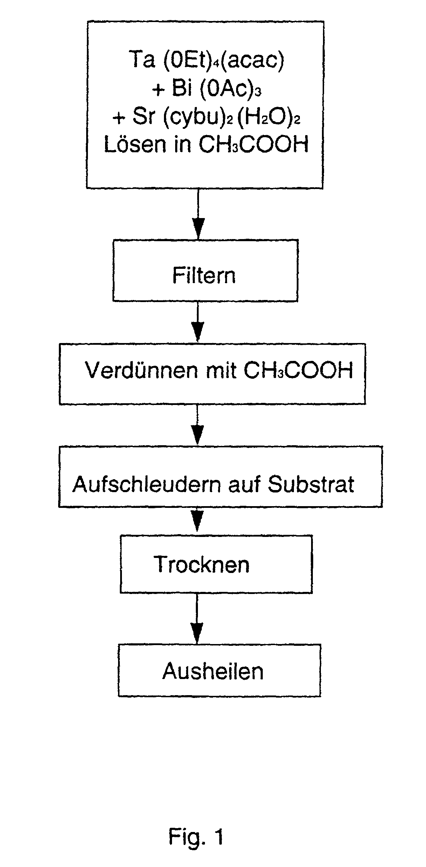

Fig 1: In diesem, in Bezug auf das Lösen des Ta-haltigen Precursors nicht erfinderischen, ansonsten jedoch für das Verständnis und die Durchführung der Erfindung förderlichen Ausführungsbeispiel werden folgende Precursoren zur Herstellung von SBT verwendet:
Ta(OEt)₄(acac) als Ta-Precursor, Bi(OAc)₃ als Bi-Precursor und Sr(cybu)₂(H₂O)₂ als Sr-Precursor (OEt = Ethoxid, acac = Acetylacetonat, OAc = Acetat, cybu = Cyclohexylbutyrat). 3,012 g des Ta-Precursors, 2,552 g des Bi-Precursors und 1,451 g des Sr-Precursors werden unter Erwärmen in 13,880 g Essigsäure gelöst. (FIG 1). Nach Abkühlen wird durch ein 0,2 µm Filter filtriert, aus der so erhaltenen Stammlösung können durch Verdünnen mit Essigsäure weitere Lösungen erhalten werden. Die Lösung wird auf das Substrat aufgetragen und bei etwa 2500 Upm 1 min abgeschleudert. Anschließend wird die Schicht getrocknet, indem sie innerhalb von 30 min auf 100° C gebracht wird. Die Pyrolyse findet bei etwa 460° C an Luft, beispielsweise in einem Gebläseofen, statt, die Dauer beträgt typischerweise 8 Stunden. Vorzugsweise wird die Temperatur mit 60° C/h hochgeregelt, um eine Verflüchtigung des Bi-Precursors zu vermeiden. Je nach Verdünnung der Stammlösung werden verschiedene SBT-Schichtdicken erhalten. Die unverdünnte Stammlösung ergibt auf einem aus Platin bestehenden Substrat eine Schichtdicke von etwa 200 nm. Die Abnahme der erreichten Schichtdicke durch Verdünnung der Stammlösung mit Essigsäure ist in der folgenden Tabelle dargestellt (Substrat = Pt).

| Lösung | Menge an Stammlösung [g] | Menge an zugefügter Essigsäure [g] | Schichtdicke [nm, ±5 nm] |
|---|---|---|---|
| 1 | Stammlösung | - | 200 |
| 2 | 0.582 | 0.014 | 195 |
| 3 | 0.587 | 0.027 | 190 |
| 4 | 0.578 | 0.040 | 185 |
| 5 | 0.582 | 0.050 | 180 |
| 6 | 0.584 | 0.056 | 175 |
| 7 | 0.577 | 0.070 | 170 |
| 8 | 0.583 | 0.082 | 160 |
| 9 | 0.579 | 0.106 | 155 |
| 10 | 0.582 | 0.122 | 150 |
| 11 | 0.575 | 0.132 | 145 |
| 12 | 0.581 | 0.155 | 140 |
| 13 | 0.581 | 0.164 | 135 |
| 14 | 0.587 | 0.184 | 130 |
| 15 | 0.582 | 0.203 | 125 |
| 16 | 0.586 | 0.221 | 120 |
| 17 | 0.578 | 0.245 | 115 |
| 18 | 0.575 | 0.282 | 110 |
| 19 | 0.581 | 0.294 | 105 |
| 20 | 0.580 | 0.333 | 100 |
| 21 | 0.578 | 0.359 | 100 |
| 22 | 0.583 | 0.378 | 95 |
| 23 | 0.585 | 0.416 | 90 |
| 24 | 0.577 | 0.449 | 90 |
| 25 | 0.577 | 0.491 | 85 |
| 26 | 0.582 | 0.536 | 85 |

Wird als Substrat SiO₂ eingesetzt, ergeben sich bei zähflüssigen Lösungen größere Schichtdicken, beispielsweise bei der Stammlösung eine Dicke von 220 nm. Bei dünnflüssigen Lösungen wird kein Schichtdickenzuwachs beobachtet.

Eine größere Schichtdicke kann mit folgender Stammlösung erzielt werden: 2,768 g des Ta-Precursors, 2,345 g des Bi-Precursors, 1,334 g des Sr-Precursors und 10,629 g Essigsäure. Mit dieser Stammlösung wird auf einem Pt-Substrat eine Schichtdicke von 280 nm erzielt. Auch in diesem Fall kann durch Verdünnen der Stammlösung mit Essigsäure die Schichtdicke herabgesetzt werden, beispielsweise wird mit einer Mischung aus 0,7 g Stammlösung mit 0,038 g Essigsäure eine Schichtdicke von 245 nm erzielt.
Größere Schichtdicken können auch durch wiederholtes Aufschleudern und Trocknen erreicht werden.

Mit dem beschriebenen Prozeß kann eine SBT-Schicht mit ferroelektrischen Eigenschaften hergestellt werden. Es besteht aber ein Problem in der Alterung der Lösung, nämlich eine Änderung der Viskosität nach etwa 1 Woche und eine Trübung nach etwa 2 Wochen, die wie oben beschrieben auf die Hydrolyse des Ta-haltigen Precursors zurückzuführen ist. Mit der im folgenden beschriebenen zweiten Ausführungsform der Erfindung kann das Problem der Alterung vermieden werden, ohne daß gefährliche Lösungsmittel oder kompliziert aufgebaute Precursoren verwendet werden müssen. Die zweite Ausführungsform wird ebenfalls am Beispiel der Herstellung eines SBT-Films erläutert.

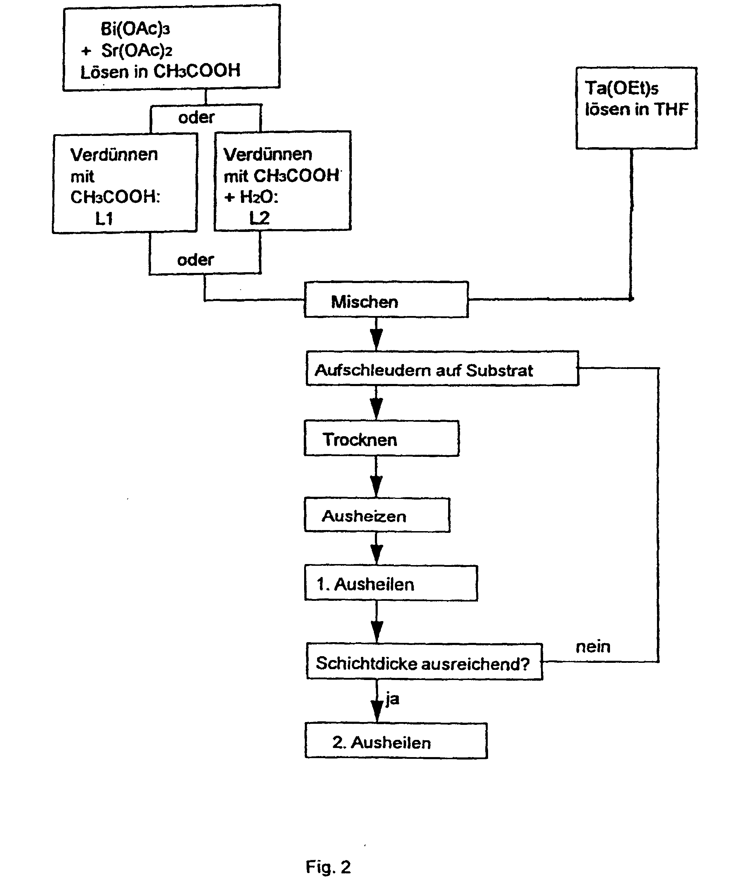

FIG 2 zeigt schematisch den Verfahrensablauf der zweiten Ausführungsform.
Es werden 2,552 g Bi(OAc)₃ und 1,451 g Sr(OAc)₂, vorzugsweise unter Erwärmen, in 13,880 g Essigsäure gelöst. Nach Auflösen der Precursoren kann mit weiterer Essigsäure verdünnt werden, beispielsweise werden 41,64 g Essigsäure hinzugesetzt. Die so erhaltene Lösung L1 ist stabil. Zur weiteren Erhöhung der Langzeitstabilität kann zu dieser Lösung noch Wasser gegeben werden, beispielsweise wird eine Menge von 2 g Wasser zugegeben (Lösung L2). Der Ta-haltige Precursor kann in gelöstem Zustand dazugemischt werden:
Als Ta-haltiger Precursor wird ebenfalls Ta (OEt)₅ verwendet, da dies eine einfache Verbindung mit einem relativ niedrigen Schmelzpunkt (etwa 30° C) ist, und in einem Lösungsmittel, beispielsweise in Tetrahydrofuran (THF), gelöst. Es werden 2,66 g Ta(OEt)₅ in 5g (ca 6 ml) THF gelöst. Anschließend wird das Gemisch in einem Spin-on-Verfahren auf das Substrat aufgebracht.
Wird das Gemisch aus der wasserhaltigen Lösung L2 und der Ta-Precursor-Lösung hergestellt, ist es wichtig, daß die Vermischung rasch erfolgt, um die Konzentration des Ta-haltigen Precursors schnell zu senken, und so eine Koagulation des Hydrolyseproduktes zu verhindern. Vorzugsweise beträgt die Zeit bis zu einer innigen Vermischung der Komponenten weniger als eine Sekunde.

Nach dem Aufbringen auf das Substrat und Abschleudern wird die Schicht zunächst getrocknet, beispielsweise 5 min lang bei 150° an Luft. Anschließend wird sie etwa 10 min lang auf 290° in normaler Atmosphäre aufgeheizt (Prebake) und dann 10 min lang bei etwa 750° an Luft ausgeheilt (annealing). Es kann aber auch ein einstufiger Ausheizschritt eingesetzt werden. Auf diese Weise wird eine etwa 40 nm dicke SBT-Schicht erzielt. Zur Herstellung größerer Schichtdicken kann der beschriebene Verfahrensablauf wiederholt werden. Wenn die gewünschte Schichtdicke erreicht ist, kann anschließend ein letzter Temperschritt durchgeführt werden (beispielsweise 800° C/1 h/O2).

Das erfindungsgemäße Verfahren kann auch mit Propionsäure und Propionaten anstelle der Essigsäure und den Acetaten durchgeführt werden. Zur Herstellung einer SBT-Schicht werden dann Bi-Propionat und Sr-Propionat und als Lösungsmittel Propionsäure (C₂H₅COOH) eingesetzt. Ferner sind Ameisensäure und ihre Salze einsetzbar.

Mit dem erfindungsgemäßen Verfahren können ferner andere keramische Schichten erzeugt werden. Als Lösungsmittel für die den Bi-haltigen Precursor und ggf. weitere Precursoren dient vorzugsweise Essigsäure, aber auch Ameisensäure oder Propionsäure, jeweils ggf. verdünnt mit Wasser. Die geeigneten Precursoren können durch einfache Versuche ermittelt werden, insbesondere kommen die Substanzklassen der Acetate oder Propionate, Ethoxyde, Acetylacetonate, einfache organische Salze der benötigten Metalle, ihre Oxyde oder die Metalle selber (bspw. Auflösen von Sr-Metall in Essigsäure) in Betracht. Wesentliche Kriterien für die Auswahl sind die dem Fachmann bekannten Eigenschaften der jeweiligen Verbindung, die Erhältlichkeit am Markt, die herstellbare Reinheit sowie die Ungefährlichkeit. Die Mengenverhältnisse der Precursoren und der Lösungsmittel in Abhängigkeit der zu erzielenden Dicke und Struktur der Schicht sind ebenfalls durch einfache Versuche bestimmbar.

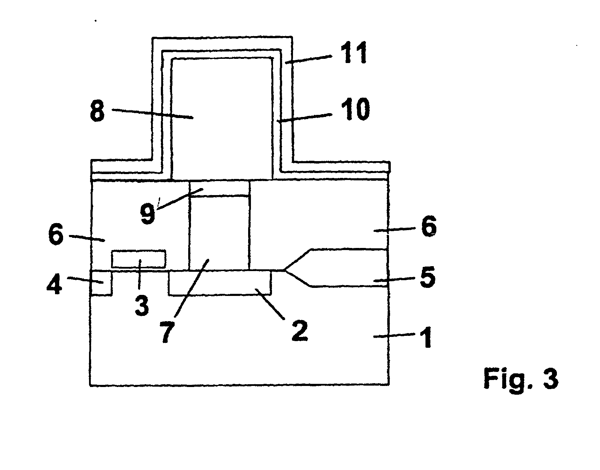

Das Verfahren kann insbesondere bei der Herstellung eines Kondensators in einer integrierten Schaltung, bspw. in einem DRAM- oder FRAM-Speicher eingesetzt werden. Ein Beispiel für einen solchen Speicher ist in Fig. 3 dargestellt. In einem Si-Halbleitersubstrat 1 ist ein MOS-Transistor mit dotierten Gebieten 2, 4 und einem Gate 3 hergestellt, der durch ein Isolationsgebiet 5 von dem Transistor einer benachbarten Speicherzelle getrennt ist. Die Anordung ist mit einer Isolationsschicht 6 abgedeckt. Über eine Anschlußstruktur 7, bspw. aus W oder PolySi, ist das dotierte Gebiet 2 durch die Isolationsschicht 6 hindurch mit einer ersten Elektrode 8 eines Speicherkondensators verbunden. Unter oder auf der ersten Elektrode kann eine Barriereschicht 9 zur Verhinderung von O₂-Diffusion (bspw. TiN) angeordnet sein. Die soweit hergestellte Struktur bildet dann das Substrat, auf das die keramische Bi-haltige Schicht 10, insbesondere eine ferroelektrische SBT-Schicht, als Speicherdielektrikum mit dem erfindungsgemäßen Verfahren aufgebracht wird. Die Speicherzelle wird vervollständigt durch die zweite Elektrode 11.

## Patentansprüche

1. Herstellverfahren für eine keramische-Schicht, die als Komponenten zumindest Bi (Wismut), Sr (Strontium) und Ta (Tantal) enthält und aus zumindest einem Bi-haltigen, einem Sr-haltigen und einem Ta-haltigen Precursor auf einem Substrat hergestellt wird,
- bei dem der Bi-haltige zusammen mit dem Sr-haltigen Precursor lediglich in einer organischen Säure CₙH₂ₙ₊₁COOH mit n = 0, 1 oder 2 sowie ggf. Wasser gelöst wird,
- bei dem der Ta-haltige Precursor in einem anderen Lösungsmittel gelöst und dann mit den gelösten Bi-haltigen und Sr-haltigen Precursoren vermischt wird,
- bei dem dann die vermischten Precursoren auf das Substrat aufgebracht werden, und
- bei dem dann durch Erwärmen die keramische Schicht hergestellt wird.

2. Herstellverfahren nach Anspruch 1,
**dadurch gekennzeichnet, daß**
es sich bei dem weiteren Lösungsmittel zum Lösen des Tahaltigen-Precursors um Tetrahydrofuran (THF) handelt.

3. Verfahren nach Anspruch 1 oder 2,
**dadurch gekennzeichnet, daß**
als Precursoren ein Salz der organischen Säure, ein Oxid, ein Ethoxid oder ein Methoxid verwendet wird.

4. Verfahren nach Anspruch 3,
**dadurch gekennzeichnet, daß**
als Bi-haltiger Precursor Bi(OAc)₃, als Sr-haltiger Precursor Sr(OAc)₂ und als Lösungsmittel Essigsäure eingesetzt werden.

5. Verfahren nach Anspruch 4,
**dadurch gekennzeichnet, daß**
die Essigsäure-Lösung mit Wasser verdünnt wird und der Mischvorgang in einem Zeitraum von maximal 1 sec erfolgt.

6. Verfahren nach einem der Ansprüche 1 bis 5,
**dadurch gekennzeichnet, daß**
die keramische Schicht eine SBT-Schicht (Strontium-Wismut-Tantalat) ist.

## Claims

1. Production method for a ceramic layer, which contains as components at least Bi (bismuth), Sr (strontium) and Ta (tantalum), and which is produced on a substrate from at least one precursor containing Bi, one precursor containing Sr and one precursor containing Ta,
- in which the precursor containing Bi is dissolved together with the precursor containing Sr merely in an organic acid CₙH₂ₙ₊₁COOH with n = 0, 1 or 2, and optionally water,
- in which the precursor containing Ta is dissolved in another solvent and then mixed with the dissolved precursors containing Bi and containing Sr,
- in which the mixed precursors are then applied to the substrate, and
- in which the ceramic layer is then produced by heating.

2. Production method according to Claim 1, **characterized in that** the further solvent for dissolving the precursor containing Ta is tetrahydrofuran (THF).

3. Method according to Claim 1 or 2, **characterized in that** a salt of the organic acid, an oxide, an ethoxide or a methoxide are used as the precursors.

4. Method according to Claim 3, **characterized in that** Bi(OAc)₃ is used as the precursor containing Bi, Sr(OAc)₂ is used as the precursor containing Sr and acetic acid is used as the solvent.

5. Method according to Claim 4, **characterized in that** the acetic acid solution is diluted with water and the mixing process is carried out in a time period of at most 1 sec.

6. Method according to any one of Claims 1 to 5, **characterized in that** the ceramic layer is an SBT (strontium-bismuth tantalate) layer.

## Revendications

1. Procédé de production d'une couche céramique qui contient comme constituants au moins Bi (bismuth), Sr (strontium) et Ta (tantale) et qui est produite sur un substrat à partir d'un précurseur contenant du Bi, d'un précurseur contenant du Sr et d'un précurseur contenant du Ta,
- dans lequel on dissout le précurseur contenant du Bi ensemble avec le précurseur contenant du Sr seulement dans un acide organique CₙH₂ₙ₊₁COOH avec n = 0, 1 ou 2 ainsi que le cas échéant dans de l'eau,
- dans lequel on dissout le précurseur contenant du Ta dans un autre solvant et on le mélange ensuite aux précurseurs dissous contenant du Bi et contenant du Sr,
- dans lequel on dépose ensuite les précurseurs mélangés sur le substrat, et
- dans lequel on produit la couche céramique ensuite en chauffant.

2. Procédé de production suivant la revendication 1, **caractérisé en ce que** l'autre solvant pour mettre en solution le précurseur contenant du Ta est le tétrahydrofuranne (THF).

3. Procédé suivant la revendication 1 ou 2, **caractérisé en ce que** l'on utilise comme précurseur un sel des acides organiques, un oxyde, un éthylate ou un méthylate.

4. Procédé suivant la revendication 3, **caractérisé en ce que** l'on utilise, comme précurseur contenant du Bi, Bi(OAc)₃, comme précurseur contenant du Sr, Sr(OAc)₂ et, comme solvant, de l'acide acétique.

5. Procédé suivant la revendication 4, **caractérisé en ce que** l'on dilue la solution d'acide acétique à l'eau et on effectue l'opération de mélange en un laps de temps de 1 s au maximum.

6. Procédé suivant l'une des revendications 1 à 5, **caractérisé en ce que** la couche céramique est une couche SBT (tantalate de strontium et de bismuth).
